(19) Europäisches Patentamt
European Patent Office
Office européen des brevets

(11) Veröffentlichungsnummer: **0 446 445 A1**

(12) **EUROPÄISCHE PATENTANMELDUNG**

(21) Anmeldenummer: **90123541.6**

(22) Anmeldetag: **07.12.90**

(51) Int. Cl.5: **C08L 81/02**, C08L 63/00, C08L 35/00, //(C08L81/02,63:00, 35:00)

(30) Priorität: **16.03.90 DE 4008461**

(43) Veröffentlichungstag der Anmeldung: **18.09.91 Patentblatt 91/38**

(84) Benannte Vertragsstaaten: **BE DE FR GB IT**

(71) Anmelder: **BAYER AG**
**W-5090 Leverkusen 1 Bayerwerk(DE)**

(72) Erfinder: **Köhler, Burkhard, Dr.**
**Mündelheimerstrasse 94**
**W-4150 Krefeld 11(DE)**
Erfinder: **Uerdingen, Walter, Dr.**
**Humperdinckstrasse 41**
**W-5090 Leverkusen 1(DE)**
Erfinder: **Wehnert. Wolfgang, Dr.**
**Bodelschwinghstrasse 14**
**W-4150 Krefeld 1(DE)**
Erfinder: **Schmidt, Manfred, Dr.**
**Erich-Klausener-Strasse 37**
**W-4150 Krefeld(DE)**
Erfinder: **Schäfer, Walter, Dr.**
**In den Weiden 25**
**W-5653 Leichlingen(DE)**
Erfinder: **Reinking, Klaus, Dr.**
**Robert-Stolz-Strasse 16**
**W-5632 Wermelskirchen 1(DE)**

(54) **Mischungen aus Polyarylensulfiden, Epoxiden, Glasfasern, gegebenenfalls säureanhydridhaltigen Polymeren und gegebenenfalls weiteren Zusätzen.**

(57) Die Erfindung betrifft Mischungen aus Polyarylensulfiden, Epoxiden, Glasfasern, gegebenenfalls säureanhydridhaltigen Polymeren und gegebenenfalls weiteren Zusätzen. Sie zeichnen sich durch gute mechanische Eigenschaften aus.

EP 0 446 445 A1

Die Erfindung betrifft Mischungen aus Polyarylensulfiden, Epoxiden, Glasfasern, gegebenenfalls säureanhydridhaltigen Polymeren und gegebenenfalls weiteren Zusätzen. Sie zeichnen sich durch gute mechanische Eigenschaften aus.

Polyarylensulfide (PAS) sind bekannt (z.B. US-A 3 354 129, EP-A 171 021). Sie sind inerte, hochtemperaturbeständige Thermoplaste, die einen hohen Füllgrad, z.B. mit Glasfasern und/oder anderen anorganischen Füllstoffen erlauben. Der Einsatz dieser Polymeren, insbesondere des Polyphenylensulfids (PPS) nimmt in Bereichen zu, die bisher Duroplasten vorbehalten waren.

PAS hat unbefriedigende mechanische Eigenschaften für einige Anwendungen im Spritzgußbereich. Insbesondere sind Randfaserdehnung und Schlagzähigkeit für die Praxis nicht ausreichend. Es hat sich daher als Vorteil erwiesen, PAS z.B. durch Abmischung mit anderen Thermoplasten in den genannten Eigenschaften zu verbessern.

Mischungen aus Maleinsäureanhydrid-gepfropften, hydrierten Dienkautschuken, Epoxiden und PAS sind bekannt (z.B. JP-A 63-118 369). Die großen Mengen an verwendeten Maleinsäureanhydrid-gepfropften Polyolefinen mit niedriger Glastemperatur verbessern die Zähigkeit, jedoch läßt sich die Biegefestigkeit nicht wesentlich steigern.

Für bestimmte Anwendungsgebiete ist das Eigenschaftsprofil derartiger Abmischungen jedoch nicht immer ganz befriedigend.

Es wurde nun gefunden, daß Abmischungen von Polyarylensulfid (PAS) mit Epoxiden, Glasfasern, gegebenenfalls Copolymeren des Maleinsäureanhydrids und gegebenenfalls anderen Zusätzen sich durch ihre mechanischen Eigenschaften auszeichnen.

Gegenstand der Erfindung sind daher Mischungen aus

A) 89,9 bis 29 Gew.-% Polyarylensulfiden, vorzugsweise Polyphenylensulfid (PPS),

B) 0,1 bis 35 Gew.-%, vorzugsweise

0,2 bis 5 Gew.-% Epoxiden der Formel (I)

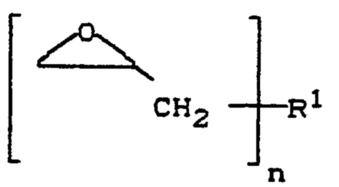

(I) ,

worin

$R^1$ für einen mindestens divalenten organischen, aliphatischen, cycloaliphatischen, aromatische, araliphatischen oder heterocyclischen Rest mit vorzugsweise 2 bis 30 C-Atomen steht, der über ein Sauerstoff- oder Stickstoffatom an den Glycidylrest gebunden ist und

n für eine Zahl größer gleich 2 steht, vorzugsweise 2 oder 3 steht,

C) 0,0 bis 35 Gew.-% Copolymerisate von Maleinsäureanhydrid mit Olefinen und/oder Vinylaromaten und/oder $\alpha,\beta$-ungesättigten Carbonsäureester und/ oder Copolymerisate von Anhydriden $\alpha,\beta$-ungesättigter Carbonsäureestern und/oder Vinylaromaten, die bevorzugt eine Glastemperatur größer 30 °C aufweisen,

D) 10 bis 79,9 Gew.-%, vorzugsweise

30 bis 60 Gew.-% Glasfasern, die vorzugsweise mit Polyurethanfilmbildnern und Aminosilan- oder Epoxysilanhaftvermittlern, besonders bevorzugt Aminosilanhaftvermittlern geschlichtet sind und

E) bis zu 300 Gew.-% bezogen auf die Summe (A + B + C + D) anderen mineralischen oder organischen Füll- und Verstärkungsstoffen und/oder anorganischen oder organischen Hilfsstoffen.

Die verwendbaren Epoxide sind bekannt und zum Teil auch handelsüblich (z.B. Lekutherm®). Sie können z.B. auch nach den DE-A 1 770 032, 1 643 777, 2 505 345, US-A 3 963 666, 3 454 421, 3 006 891, 4 582 892, EP-A 143 075 oder Angew. Makromol. Chemie 63, 63 (77) hergestellt werden. Weiterhin sind sie z.B. aus in Methoden der organischen Chemie (Houben-Weyl), Band E 20, Georg Thieme Verlag Stuttgart, New York, 4. Aufl. 1987, Seite 1891-1950 und der dort zitierten Literatur bekannt.

Bevorzugte Epoxide der Formel (I) sind Bisglycidyl-bisphenol A, Bisglycidyl-terephthalat, Bisglycidyltetrahydrophthalat, Triglycidyl-isocyanurat, Triglycidylurazol, Glycidylether von Phenol-Formaldehydkondensaten, N,N-Bis-[oxiranylmethyl]-[4-(oxiranylmethoxy)-phenyl]amin, Bis-[4-bis-(oxiranylmethyl)-amino]-phenyl]-methan.

Die erfindungsgemäßen Maleinsäureanhydridcopolymere werden vorzugsweise nach dem Verfahren der radikalischen Polymerisation hergestellt. MSA-Copolymere werden z.B. in Maleic Anhydrid, S. 413 Plenum Press, New York, London 1982 beschrieben. MSA-Copolymere sind z.T. kommerziell erhältlich unter dem

Namen Lotader® der Fa. CdF.

Erfindungsgemäß werden handelsübliche, gegebenenfalls mit Polyurethanfilmbildnern und Aminosilan- oder Epoxysilanhaftvermittlern geschlichtete Glasfasern eingesetzt. Sie haben einen Durchmesser von 1 bis 20 µm, vorzugsweise von 5 bis 13 µm. Es können auch Endlosglasfasern eingesetzt werden und/oder Herstellungsverfahren gewählt werden, bei denen die Länge der Fasern in der fertigen Abmischung 0,05 bis 10 mm, vorzugsweise 0,1 bis 2 mm, beträgt. Es können auch Endlosfasern (Rovings) eingesetzt werden in Verfahren zur Herstellung von endlosverstärktem Unidirektionalverbund.

Gegebenenfalls können auch - insbesondere teilweise - anstelle der Glasfasern handelsübliche Glaskugeln eingesetzt werden, z.B. Ballotini-Glaskugeln.

Als weitere, mineralische Füllstoffe oder Zusatzstoffe seien Glimmer, Talkum, Quarzmehl, Metalloxide und Sulfide wie z.B. $TiO_2$, ZnO, ZnS, Graphit, Ruß, Fasern, z.B. aus Quarz oder Kohlenstoff, Carbonate wie z.B. $MgCO_3$, $CaCO_3$ oder Sulfat wie z.B. $CaSO_4$, $BaSO_4$ genannt.

Als weitere übliche Zusatzstoffe können Pigmente, Entformungsmittel, E-Wachse, Fließhilfsmittel, Nucleierungsmittel oder Stabilisatoren eingesetzt werden.

Die erfindungsgemäßen Mischungen können auf übliche Art und Weise durch Extrusion hergestellt werden.

Die erfindungsgemäßen Mischungen können auf übliche Weise zu Formteilen, Halbzeug, Leiterplatten, Fasern, Folien, Profilen usw. verarbeitet werden. Die erfindungsgemäßen Mischungen können generell in vorteilhafter Weise dort eingesetzt werden, wo thermoplastisch verarbeitbare Massen eingesetzt werden.

Beispiele

Die Herstellung der erfindungsgemäßen Mischungen erfolgte auf einem Doppelwellenextruder ZSK 32 von Werner und Pfleiderer bei 320°C.

Das verwendete PPS wies eine Schmelzviskosität von 45 Pa.s (306°C), Schubspannung = 1.000 l/s auf und wurde nach EP-A 171 021 hergestellt.

Als Glasfasern wurde die mit Polyurethanfilmbildner und Aminosilanhaftvermittler geschlichtete Schnittglasfaser Bayer CS 7916® zu 40 Gew.-% eingesetzt.

Die Mischungen wurden granuliert und zu Prüfstäben (z.B. der Maße 80 x 10 x 4 mm) verspritzt. Diese wurden hinsichtlich Biegefestigkeit, Randfaserdehnung, Biegemodul und Schlagzähigkeit $a_n$ (reversed notched ISO 180) untersucht.

Vergleichsbeispiel

Gemischt wurden 60 % PPS mit 40 % Glasfaser.

Beispiel 1

Gemischt wurden 58 % PPS, 40 % Glasfaser, 1 % Triglycidylisocyanurat und 1 % eines Copolymers aus 15 % Maleinsäureanhydrid, 30 % Butylacrylat, 30 % Methylmethacrylat und 25 % Styrol.

Folgende Tabelle faßt die mechanischen Eigenschaften zusammen:

| Beispiel | Biegefestigkeit (MPa) | Randfaserdehnung (%) | Biegemodul (MPa) | Izod-Schlagzähigkeit ($kJ/m^2$) |
|---|---|---|---|---|
| Vergleich | 250 | 1,9 | 13.000 | 30 |
| 1 | 311 | 2,5 | 12.900 | 47 |

**Patentansprüche**

1. Mischungen aus
   A) 89,9 bis 20 Gew.-% Polyarylensulfiden,
   B) 0,1 bis 35 Gew.-% Epoxiden der Formel (I)

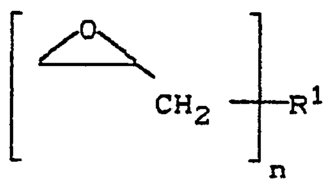

(I),

   worin
   $R^1$ für einen mindestens divalenten organischen Rest mit 2 bis 30 C-Atomen steht, der über ein Sauerstoff- oder Stickstoffatom an den Glycidylrest gebunden ist und
   n für eine Zahl größer gleich 2 steht,
   C) 0,0 bis 35 Gew.-% Copolymerisate von Maleinsäureanhydrid mit Olefinen und/oder Vinylaromaten und/oder α,β-ungesättigten Carbonsäureestern und/oder Copolymerisate von Anhydriden α,β-ungesättigten Carbonsäuren mit anderen Olefinen und/oder α,β-ungesättigten Carbonsäureestern und/oder Vinylaromaten,
   D) 10 bis 79,9 Gew.-% Glasfasern und/oder anderen mineralischen oder organischen Füll- und Verstärkungsstoffen und
   E) bis zu 300 Gew.-% bezogen auf die Summe (A + B + C + D) anorganischen oder organischen Hilfsstoffen.

2. Verwendung der Mischungen nach Anspruch 1 zur Herstellung geformter Körper.

Europäisches Patentamt

# EUROPÄISCHER RECHERCHENBERICHT

Nummer der Anmeldung

EP 90 12 3541

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN, Band 9, Nr. 119 (C-282)[1842], 23. Mai 1985; & JP-A-60 008 359 (DAINIPPON INK) 17-01-1985 * Insgesamt * | 1 | C 08 L 81/02<br>C 08 L 63/00<br>C 08 L 35/00 //<br>(C 08 L 81/02<br>C 08 L 63:00<br>C 08 L 35:00 ) |
| X | PATENT ABSTRACTS OF JAPAN, Band 13, Nr. 275 (C-610)[3623], 23. Juni 1989; & JP-A-10 69 657 (TORAY IND) 15-03-1989 * Insgesamt * | 1 | |
| D,A | PATENT ABSTRACTS OF JAPAN, Band 12, Nr. 365 (C-532)[3212], 29. September 1988; & JP-A-63 118 369 (DAINIPPON INK) 23-05-1988 | | |
| X | EP-A-0 104 543 (DAINIPPON INK) * Seite 5, Zeilen 17-35; Beispiele 15-18 * | 1 | |
| A | WPIL, FILE SUPPLIER, AN= 88011447, Derwent Publications LTD, London, GB; & JP-A-62 275 122 (ASAHI GLASS) 30-11-1987 | | **RECHERCHIERTE SACHGEBIETE (Int. Cl.5)** |
| A | WPIL, FILE SUPPLIER, AN= 85009427, Derwent Publications LTD, London GB; & JP-A-59 207 921 (DAINIPPON INK) 26-11-1984 | | C 08 L |
| A | EP-A-0 044 136 (ASAHI GLASS) * Ansprüche; Beispiel 2 * | 1,2 | |

Der vorliegende Recherchenbericht wurde für alle Patentansprüche erstellt

| Recherchenort | Abschlußdatum der Recherche | Prüfer |
|---|---|---|
| Den Haag | 10 Juni 91 | KLIER E.K. |

KATEGORIE DER GENANNTEN DOKUMENTE

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze

E: älteres Patentdokument, das jedoch erst am oder nach dem Anmeldedatum veröffentlicht worden ist
D: in der Anmeldung angeführtes Dokument
L: aus anderen Gründen angeführtes Dokument

&: Mitglied der gleichen Patentfamilie, übereinstimmendes Dokument